Europäisches Patentamt

European Patent Office

Office européen des brevets

(11) Publication number:   **0 100 677**
                         **B1**

(12)   **EUROPEAN PATENT SPECIFICATION**

(45) Date of publication of patent specification: **22.03.89**   (51) Int. Cl.⁴: **H 01 L 29/06**

(21) Application number: **83304446.4**

(22) Date of filing: **01.08.83**

(54) Semiconductor devices including lateral-type transistors.

(30) Priority: **02.08.82 JP 133780/82**

(43) Date of publication of application:
**15.02.84 Bulletin 84/07**

(45) Publication of the grant of the patent:
**22.03.89 Bulletin 89/12**

(84) Designated Contracting States:
**DE FR GB**

(56) References cited:
**DE-A-3 023 616**

**IBM TECHNICAL DISCLOSURE BULLETIN, vol.
18, no. 3, August 1975, page 725, New York,
US; I. ANTIPOV et al.: "Preventing surface
parasitic currents in lateral bipolar transistors"**

(73) Proprietor: **FUJITSU LIMITED**
**1015, Kamikodanaka Nakahara-ku
Kawasaki-shi Kanagawa 211 (JP)**

(72) Inventor: **Isogai, Hideaki
4-11-13, Minamisawa
Higashikurume-shi Tokyo 180-03 (JP)**

Inventor: **Ono, Chikai
322, Seki, Tama-ku
Kawasaki-shi Kanagawa 214 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

## Description

The present invention relates to semiconductor devices including lateral-type transistors.

As is well known, lateral-type transistors are transistors in which both an emitter and a collector are arranged on the same surface layer of the semiconductor substrate. This type of transistor is used, for example, as a load element un the memory cells of some memory circuits. Thus, lateral-type PNP transistors (hereinafter, "PNP transistor") have a construction similar to that of conventional P-channel MOS transistors; the N-type base region of PNP transistors resembles the channel in P-channel MOS transistors. Such PNP transistors may suffer from so-called channel leakage. Channel leakage is caused by conduction between the emitter and collector of a PNP transistor that arises when negative (−) charges (usually called "contamination") are injected into an insulation layer formed on the base region. It should be understood that this problem of channel leakage is already well known.

In order to avoid channel leakage, it has been proposed to mount above the base region, an electrode to which positive (+) voltage is applied, such that said negative charges are attracted toward the upper side of said insulation layer.

The above-mentioned positive electrode may easily be formed above the base region when the IC is not densely packaged. However, with the recent increase in IC packaging densities, the smallness of the area that is generally available for mounting the positive electrodes may make it difficult to ensure that these positive electrodes are able to achieve their intended function of preventing channel leakage.

In the prior art, if the widths of the individual electrodes are made as small as possible, such as to attain higher IC packaging densities, a problem arises in that the smaller the width, the more likely that in the insulation layers are not completely covered by the respective positive electrodes. Thus, even though a positive electrode is actually present here in each PNP transistor, if the bases of the transistors are not fully covered, the PNP transistors may still exhibit channel leakage.

An embodiment of the present invention can be made to provide a lateral-type PNP transistor having a P-type collector region, a P-type emitter region, and an N-type base region, all of which contact an isolation region, the isolation region projecting partially into just said base region.

Reference will now be made, by way of example, to the accompanying drawings, wherein:

Figure 1 is a circuit diagram of one example of circuitry to which the present invention may be applied;

Figure 2 is a cross-sectional view of a lateral type PNP transistor, illustrating the problem of channel leakage inherent therein;

Figure 3 is a plan view of a conventional lateral-type PNP transistor with an identical cross-section to that of the transistor shown in Figure 2;

Figure 4 is a plan view showing an embodiment of a semiconductor device according to the present invention;

Figure 5 is a plan view of a semiconductor device identical with that of Figure 4, except for the use of wiring of a different size;

Figure 6 is a plan view of one example of an application based on the embodiment of Figure 4; and

Figure 7 is a plan view of a different example of an application based on the embodiment of Figure 4.

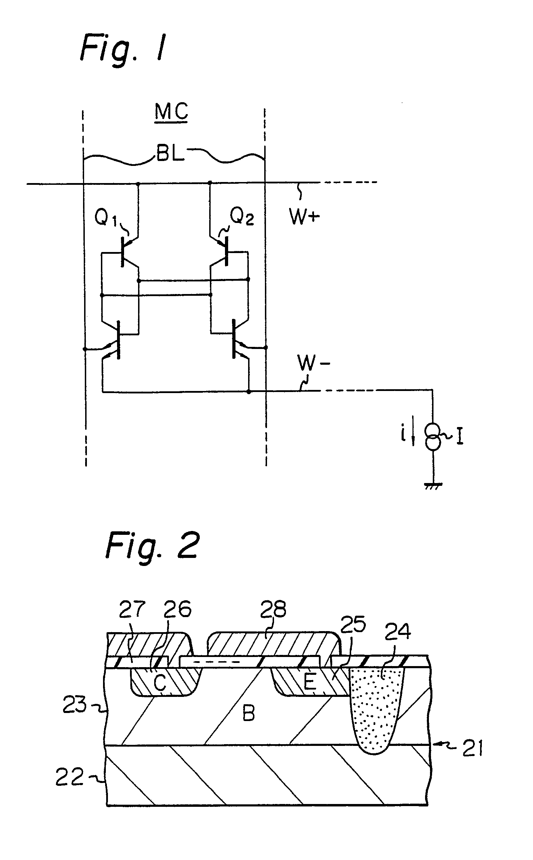

Figure 1 is a circuit diagram of one example of conventional circuitry to which the present invention can be applied. More specifically, Figure 1 shows a typical memory cell in a memory circuit. As is widely known, memory cells (MC) are arranged in a matrix at each of the intersecting points between pairs of bit lines BL and word lines. The memory cell in Figure 1 is typical of those in static-type memory circuits. Each of said word lines consists of a positive (+) side word line $W_+$ and negative (−) side word line $W_-$. The word line $W_-$ is connected to a constant current source I, and passes a hold current i therethrough.

In Figure 1, particular attention should be paid to transistors $Q_1$ and $Q_2$, each of which is a load element of the memory cell MC. Previously, the load element was usually a load resistor. However, to reduce the hold current i, the trend of late has been to use a load transistor as the load element. Each of these load transistors $Q_1$ and $Q_2$ corresponds to the above lateral-type PNP transistor, in which the above-mentioned problem of channel leakage occurs.

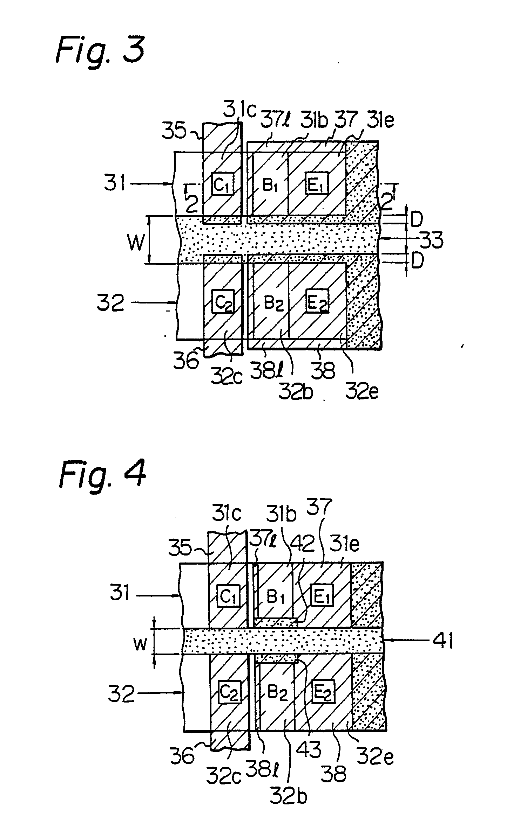

Figure 2 is a cross-sectional view of a lateral-type PNP transistor which illustrates the problem of channel leakage inherent therein (Figure 2 is similar to the view taken along line 2—2 in Figure 3 mentioned hereinafter). In Figure 2, the reference numeral 21 represents a semiconductor substrate composed of, for example, an epitaxial layer 22 and an N-type layer 23. The reference numeral 24 represents an isolation region for electrically separating adjacent circuit elements from each other. In the N-type layer 23, particularly where a base region B is formed therein, an emitter E and a collector C are formed, respectively, as P-type regions 25 and 26 by a diffusion process whereby both emitter E and collector C are arranged on the same surface layer.

As seen from Figure 2, an insulation layer 27 is formed on the surface of the semiconductor substrate 21; it should be recognized that, during the process for forming this insulation layer 27, negative charges are sometimes injected thereinto. If the negative charges thus injected are located above the base region B, since, as previously mentioned, the PNP transistors also behave as P-channel MOS transistors, the path between the emitter E and the collector C becomes conductive, resulting in channel leakage. In order to avoid such channel leakage, an electrode having a positive voltage is usually mounted above the base region B, such as to attract the negative charges to the upper side of insulation layer 27 (see dashed lines). In this case, it is economically preferable to fabricate this positive electrode integral with an emitter wiring 28. This is because, in conventional PNP transistors, the emitter always receives a positive voltage. The emitter wiring 28 is thus distributed such that it covers not only the emitter region E, but also the base region B, as shown in Figure 2.

Figure 3 is a plan view of a conventional lateral-type PNP tansistor having a cross-section similar to that of the transistor shown in Figure 2. It should be noted that Figure 3 exemplifies an arrangement where two PNP transistors (corresponding to $Q_1$ and $Q_2$ of Figure 1) face each other across an isolation region, sandwiched therebetween, such as to conform with the circuit arrangement of Figure 1. In Figure 3, reference numeral 31 represents a first lateral-type PNP transistor that faces a second lateral-type PNP transistor 32 across an isolation region 33 sandwiched therebetween. In PNP transistor 31, the reference characters 31c, 31b and 31e are respectively a collector region, a base region, and an emitter region thereof, while reference symbols $C_1$ and $E_1$, enclosed by square lines, represent a collector contact and an emitter contact, respectively. Similarly, in PNP transistor 32, reference characters 32c, 32b and 32e respectively represent a collector region, a base region, and an emitter region, while reference symbols $C_2$ and $E_2$, enclosed by square lines, represent a collector contact and an emitter contact, respectively.

Reference numerals 35 and 36 represent collector wirings, while reference numerals 37 and 38 represent emitter wirings. In Figure 3 and on, hatched lines and dotted areas are used, not for the usual purpose of representing regions in cross-section, but to help the viewer distinguish between the different components. Of these wiring, embodiments of the invention particularly concern portions $37_1$ and $38_1$, i.e., the above-mentioned positive electrodes for preventing channel leakage that extend from respective emitter wirings 37 and 38 to completely cover respective base regions $31_b$ and $32_b$.

Self-alignment is generally well known as a means for achieving high IC packing densities. The arrangement illustrated in Figure 2 was also created with the aid of self-alignment. Here, the diffusion areas for forming collector regions $31_c$ and $32_c$ and emitter regions $31_e$ and $32_e$ are self-aligned by isolation region 33. With self-alignment, the pattern densities in the IC can be considerably increased. However, recent demand for higher pattern densities has grown very strong, as a result of which an attempt is often made to set the width W of the isolation region 33 smaller than usual. This inevitably results, however, in bringing emitter wirings 37 and 38 closer to each other, increasing the likelihood of an electric short therebetween. To avoid the possibility of such an electric short occurring, width D of the margin for each wiring must be minimized. One alternative is to not have electrodes $37_e$ and

$38_e$ completely cover base regions $31_b$ and $31_c$, thus creating portions not covered the electrodes. However, this construction is likely to result again in channel leakage. It should be noted that, although the above problem was explained for an example in which two PNP transistors 31 and 32 were used, identical problems will similarly arise in cases where three or more PNP transistors with the isolation regions located therebetween are provided, or when a single PNP transistor is provided.

An embodiment of the present invention can provide a semiconductor device in which the width W of the isolation region is reduced for higher pattern densities and channel leakage prevented from occurring therein by a very simple means.

Figure 4 is a plan view showing an embodiment of a semiconductor device according to the present invention. In Figure 4, members are represented by the same reference numerals or characters as the corresponding members in Figure 3; these numerals and characters are used to represent like members in the later figures as well. The only difference between the embodiments shown in Figures 3 and 4 lies in an isolation region 41. The width w of this isolation layer 41 is narrower than the width W of the isolation region in Figure 3. The smaller width w is intended to allow higher pattern densities. However, the smaller the width of the isolation region, the closer the emitter wirings 37 and 38 approach to each other. In the worst case, these emitter wirings may become electrically shorted on account of a variance in wiring size during manufacturing. To avoid such shorting, the width of each emitter wiring must be made as small as possible, such as to reduce the width D of margin of the wirings (see Figure 3) to essentially zero.

However, if the width D is reduced to essentially zero, portions not covered by the extended emitter wirings $37_1$ and $38_1$ may be formed above the base regions due to variances in wiring dimensions arising during manufacturing, causing the base regions to be left at least partially uncovered. If such uncovered portions exist, channel leakage will tend to occur.

In Figure 4, the width of isolation region 41 is widened somewhat at the portion facing each of the base regions by providing projections 42 and 43 of the isolation region 41, said projections extending from the body of isolation region 41 into respective base regions $31_b$ and $32_b$. Thus, even if base regions $31_b$ and $32_b$ are manufactured with considerably small widths due to variances in the manufacturing process, they remain completely covered by respectively extended emitter wirings $37_1$ and $38_1$, which can prevent channel leakage from occurring.

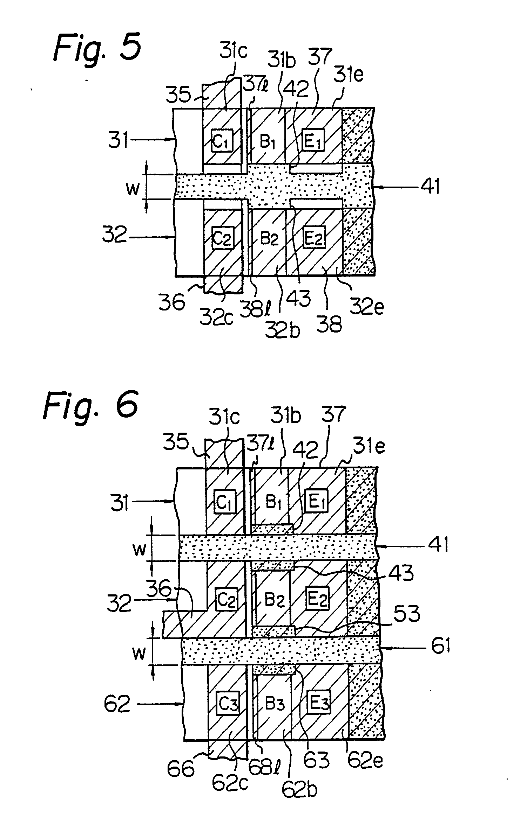

Figure 5 is a plan view of a semiconductor device identical with that of Figure 4, except that it is manufactured with wiring of a different size. In the embodiment shown in Figure 5, wirings $31_e$, $32_e$, $37_1$, and $38_1$ are manufactured at the minimum limit in a predetermined range in allowable design size, this limit corresponding to the worst possible case of wiring size variance during the manufacturing process. Here, the side of emitter wiring $31_e$ provided with electrode $37_l$ is located far from one side of the body of isolation region 41. In Figure 5, this also applies to the sides of wirings $32_e$ and $38_l$ with respect to the other side of region 41. In this worst case, referring to PNP transistor 31 as a representative example, the base region $31_b$ can still be completely covered by electrode $37_l$ because one side of base region $31_b$ is located apart from one side of the body of isolation region 41 facing thereto.

The space thus formed bevween the facing sides of regions $31_b$ and 41 are filled with said projections 42 having the same composition as region 41 such that the self-alignment method described above remains applicable to recessed base region $31_b$.

Figure 6 is a plan view of one example of an application based on the embodiment of Figure 4. In this example, three or more identical PNP transistors are fabricated according to the present invention. However, for the sake of simplicity, only three PNP transistors are shown in Figure 6. The third PNP transistor is reprsented as a whole by reference numeral 62. Reference numerals 53 and 63 represent the projections constituting a feature of the present invention. Members $C_3$, $B_3$ and $E_3$ are identical to members $C_1$, $C_2$, $B_1$, $B_2$ and $E_1$, $E_2$. The members represented by reference characters $62_c$, $68_l$, $62_e$ and 66 are identical respectively to members $32_c$, $38_l$, $32_e$, and 36 shown in Figures 4 and 5.

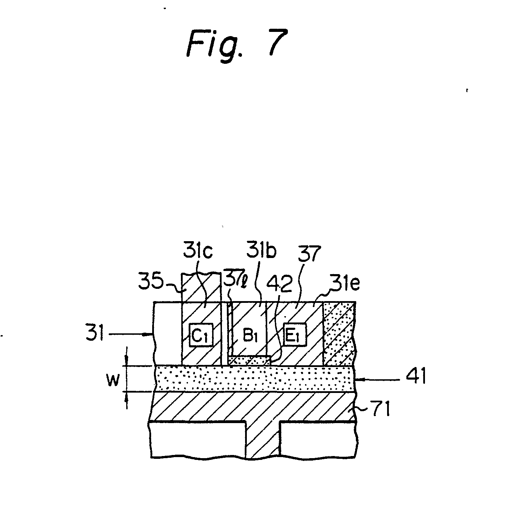

Figure 7 is a plan view of another example of an application based on the embodiment of Figure 4. In this example, the PNP transistor 31 does not face another PNP transistor, but rather conductor lead 71, with isolation region 41 sandwiched therebetween. In the embodiment shown in Figure 7, it is also true that the width D (Figure 3) of margin in the wiring should be reduced to substantially zero. This results in the formation of an uncovered portion above the base region $31_b$ in the absence of projection 42.

As explained above, embodiments of the present invention, can provide a simple means for attaining high IC packaging densities while protecting against channel leakage.

## Claims

1. A semiconductor device comprising at least one lateral-type PNP transistor having a P-type collector region, a P-type emitter region, an N-type base region, and an emitter wiring partially extended such as to entirely cover said base region, said collector and emitter regions being formed such as to directly contact an isolation region adjacent thereto, but said base region being formed such as to contact said isolation region via a projection extending partially therefrom, said partially extended emitter wiring being disposed above said projection.

2. A semiconductor device as set forth in Claim 1, wherein said projection and said isolation region are integral with each other.

3. A semiconductor device as set forth in Claim 1 or 2, wherein self-alignment is established between said isolation region and said emitter and collector regions and also between said base region and said projection.

4. A semiconductor device as set forth in Claim 1, 2 or 3, wherein said projection is formed with a predetermined width between the body of said isolation region and said base region, which width is about equal to the value corresponding to the minimum limit in a predetermined range in allowable design size for said partially extended emitter wiring.

5. A semiconductor device comprising a semiconductor layer in which is formed a lateral-type transistor, having at a main surface of the semiconductor layer a collector region and a base region and an emitter region, and an isolation region for insulating the transistor from other portions of the device; the said collector region, base region and emitter region having respective peripheral boundary portions which extend adjacent to respective successive portions of one lateral boundary of the isolation region; and there being an electrical connection layer which is connected to and overlies one of the said collector and emitter regions and extends additionally over ths said base region so as to overlie that region substantially completely; characterised in that the said peripheral boundary portion of the base region is displaced, in relation to the said peripheral boundary portions of the collector and emitter regions, in the direction away from the said isolation region.

## Patentansprüche

1. Halbleitervorrichtung mit wenigstens einem PNP-Transistor vom lateralen Typ, der einen P-Typ-Kollektorbereich, einen P-Typ-Emitterbereich, einen N-Typ-Basisbereich und eine Emitterverdrahtung hat, die teilweise so erweitert ist, daß sie den genannten Basisbereich vollständig bedeckt, wobei die genannten Kollektor- und Emitterbereiche so geformt sind, daß sie direkt einen an ihnen angrenzenden Isolationsbereich kontaktieren, der genannte Basisbereich jedoch so geformt ist, daß er den genannten Isolationsbereich über eine Vorsprung, der teilweise von ihm vorsteht, kontaktiert und die genannte teilweise erweiterte Emitterverdrahtung oberhalb des genannten Vorsprungs angeordnet ist.

2. Halbleitervorrichtung nach Anspruch 1, bei der der genannte Vorsprung und der genannte Isolationsbereich einstückig miteinander ausgebildet sind.

3. Vorrichtung nach Anspruch 1 oder 2, bei der eine Selbstausrichtung zwischen dem genannten Isolationsbereich und den genannten Emitter- und Kollektorbereichen und auch zwischen dem genannten Basisbereich und dem genannten Vorsprung hergestellt ist.

4. Halbleitervorrichtung nach Anspruch 1, 2 oder 3, bei der der genannte Vorsprung mit einer vorbestimmten Breite zwischen dem Körper des genannten Isolationsbereiches und dem genannten Basisbereich gebildet ist, welche Breite etwa gleich dem Wert ist, der der minimalen Grenze in einem vorbestimmten Bereich in zulässiger Auslegungsgröße für die genannte teilweise erweiterte Emitterverdrahtung entspricht.

5. Halbleitervorrichtung mit einer Halbleiterschicht, in der ein Lateral-Typ-Transistor gebildet ist, der eine Hauptoberfläche der Halbleiterschicht, einen Kollektorbereich und einen Basisbereich und einen Emitterbereich hat, und einen Isolationsbereich zum Isolieren des Transistors von anderen Abschnitten der Vorrichtung; bei der der genannte Kollektorbereich, der Basisbereich und Emitterbereich jeweilige periphere Grenzabschnitt haben, welchen sich angrenzend an die jeweilig folgenden Abschnitte einer seitlichen Grenze des Isolationsbereiches erstrecken; und bei der es eine elektrische Verbindungsschicht gibt, die mit einem der genannten Kollektor- und Emitterbereich verbunden und ihm überlagert ist und sich zusätzlich über den genannten Basisbereich so erstreckt, daß sie jenen Bereich im wesentlichen vollständig überlagert; dadurch gekennzeichnet, daß der genannte periphere Grenzabschnitt des Basisbereiches versetzt ist, in Relation zu den genannten peripheren Grenzabschnitten der Kollektor- und Emitterbereiche, in der Richtung von dem genannten Isolationsbereich fort.

**Revendications**

1. Dispositif à semiconducteurs comprenant au moins un transistor PNP de type latéral possédant une région de collecteur de type P, une région d'émetteur de type P, une région de base de type N et un câblage d'émetteur se prolongeant partiellement de manière à recouvrir entièrement ladite région de base, lesdites régions de collecteur et d'émetteur étant formées de manière à être en contact direct avec une région d'isolation qui leur est adjacente, tandis que ladite région de base est formée de manière à être en contact avec ladite région d'isolation par l'intermédiaire d'une partie saillante se prolongeant partiellement de celle-ci, ledit câblage d'émetteur partiellement prolongé étant disposé au-dessus de ladite partie saillante.

2. Dispositif à semiconducteurs selon la revendication 1, où ladite partie saillante et ladite région d'isolation sont solidairement formées l'une avec l'autre.

3. Dispositif à semiconducteurs selon la revendication 1 ou 2, où un auto-alignement est établi entre ladite région d'isolation et lesdites régions d'émetteur et de collecteur, ainsi qu'entre ladite région de base et ladite partie saillante.

4. Dispositif à semiconducteurs selon la revendication 1, 2 ou 3, où ladite partie saillante est dotée d'une largeur prédéterminée entre le corps de ladite région d'isolation et ladite région de base, laquelle largeur est aproximativement égale à la valeur correspondant à la limite minimal d'un intervalle prédéterminé de dimensions prévus admissibles pour ledit câblage d'émetteur partiellement prolongé.

5. Dispositif à semiconducteurs comprenant une couche semiconductrice dans laquelle est formé un transistor de type latéral, possédant au niveau d'une surface principale de la couche semiconductrice une région de collecteur, une région de base et une région d'émetteur, et une région d'isolation destinée à isoler le transistor vis-à-vis d'autres parties du dispositif; ladite région de collecteur, ladite région de base et ladite région d'émetteur possédant des parties de frontière périphérique respectives qui s'étendant au voisinage de parties successives respectives d'une frontière latérale de la région d'isolation; une couche de connexion électrique étant prévue qui est connectée à l'une desdites régions de collecteur et d'émetteur et passe au-dessus de celle-ci et qui s'étend en outre au-dessus de ladite région de base de manière à passer au-dessus de cette région de façon sensiblement totale; caractérisé en ce que ladite partie de frontière périphérique de la région de base s'écarte, relativement auxdites parties de frontière périphérique des régions de collecteur et d'émetteur, suivant une direction d'éloignement par rapport à ladite région d'isolation.

## Fig. 1

## Fig. 2

*Fig. 3*

*Fig. 4*

## Fig. 5

## Fig. 6

# Fig. 7